# EUROPÄISCHE PATENTSCHRIFT

(11) **EP 3 003 676 B1**
(45) Veröffentlichungstag und Bekanntmachung des Hinweises auf die Patenterteilung: **05.04.2017**
(21) Anmeldenummer: 14728143.0
(22) Anmeldetag: 27.05.2014
(51) Int. Cl.: B29C 45/14, H03K 17/96

(54) **VERFAHREN ZUM HINTERSPRITZEN EINES FOLIENKÖRPERS**
METHOD FOR BACK-INJECTION MOLDING A FOIL BODY
PROCÉDÉ D'INJECTION PAR L'ARRIÈRE SUR UN CORPS EN FEUILLES

(30) Priorität: 05.06.2013 DE 102013105802
(43) Veröffentlichungstag der Anmeldung: 13.04.2016
(73) Patentinhaber: PolyIC GmbH & Co. KG, 90763 Fürth (DE)
(72) Erfinder: ULLMANN, Andreas, 90513 Zirndorf (DE); FIX, Walter, 90763 Fürth (DE)
(74) Vertreter: Louis Pöhlau Lohrentz
(86) Internationale Anmeldenummer: PCT/EP2014/060946
(87) Internationale Veröffentlichungsnummer: WO 2014/195188

(56) Entgegenhaltungen:
- WO-A1-2010/072163
- US-A1- 2012 267 229
- BAUER R: "Touchskin - nicht Touchscreen", PLASTVERARBEITER, HUETHIG GMBH, HEIDELBERG, DE, Bd. 61, Nr. 12, 1. Dezember 2010 (2010-12-01), Seiten 30-33, XP001573740, ISSN: 0032-1338

## Beschreibung

Die Erfindung betrifft einen Folienkörper, ein Verfahren zum Hinterspritzen eines Folienkörpers und ein Hinterspritzwerkzeug dazu. Insbesondere betrifft die Erfindung ein Verfahren zum Hinterspritzen von Schichtelektroden für Berührungsbildschirme.

Schichtelektroden bilden das Herzstück eines Berührungsbildschirms. In diesen Schichtelektroden werden die einzelnen Sensorfelder kontaktiert und die Zuleitungen am Rand der Schichtelektrode zusammengeführt, gebündelt und für die elektrische Anbindung an das Touchmodul oder den Controller als so genannter Tail in-beispielsweise- ZIF-Stecker gesteckt.

Der Tail ist dabei Bestandteil der Folie, die die Schichtelektrode bereitstellt. Das als "Tail" bezeichnete Teilstück dieser Folie unterscheidet sich von dem größeren Teil der Schichtelektrode dadurch, dass es eine andere Belegung mit Leitungen als die Schichtelektrode aufweist, eben die gebündelten Zuleitungen zu den Sensor-Elektrodenfeld-Kontaktierungen der transparenten Schichtelektrode. Die Folie am Tail kann, muss aber nicht transparent ausgestaltet sein.

Momentan ist die Entwicklung der Technologie so weit, dass bevorzugt flexible Schichtelektroden, die Trägerkörper wie Folien haben, bevorzugt eingesetzt werden. Derartige Schichtelektroden sind beispielsweise aus der DE 10 2012 112 445.0 bekannt.

Üblicherweise werden diese Schichtelektroden zu Berührungsbildschirmen laminiert und der Bereich, welcher den Tail umfasst, wird von der verklebenden Schicht ausgespart, wodurch dann dieser nicht fest an das Gehäuse, beispielsweise die "Lens" oder den "Cover" gebunden wird.

Derartige schichtelektrode sind beispielweise aus der US 2012267229 bekannt. XP001573740 offenbart ein Verfahren zum Hinterspritzen einer Schichtelektrode.

Wirtschaftlich interessant ist die Aufgabe des Laminierens der Schichtelektroden zugunsten eines einfachen Hinterspritz-Prozesses.

Beim Hinterspritzen der Schichtelektroden ist es wichtig, die Hinterspritzung der Zuleitungen, insbesondere des Tails zu vermeiden, damit dieser nicht mit verklebt wird.

Bislang werden mehrere Möglichkeiten angedacht, den Tail vor dem Hinterspritzmaterial zu schützen. Beispielsweise kann der Tail durch Einbringen eines Schiebers vor dem Hinterspritzmaterial geschützt werden. Dazu ist erforderlich, dass die Schichtelektrode, die bei wirtschaftlich interessanten Prozessen durch Roboter im Hinterspritzwerkzeug platziert wird, ganz passgenau positioniert wird. Dies ist aber nur kostspielig realisierbar.

Aufgabe der vorliegenden Erfindung ist es daher, eine kosteneffiziente Möglichkeit zu schaffen, damit bei der Verarbeitung der Schichtelektrode durch Hinterspritzen Bereiche der Schichtelektrode, die nicht hinterspritzt werden sollen, wie beispielsweise der Tail, frei bleiben.

Diese Bereiche werden im Folgenden "nicht zu hinterspritzende oder frei zu bleibende Bereiche" genannt und bezeichnen beispielsweise den Tail, der ein Teil der Schichtelektrode ist, aber zur Herstellung des Berührungsbildschirms nicht wie diese hinterspritzt wird.

Diese Aufgabe wird durch den Gegenstand der vorliegenden Anmeldung, wie in den Ansprüchen, der Beschreibung und den Figuren offenbart, gelöst.

Allgemeine Erkenntnis der Erfindung ist es, eine Opferfolie beim Hinterspritzen auf einen Bereich der Schichtelektrode, beispielsweise den Tail, so anzubringen, dass dieser effektiv und kostengünstig vor dem Hinterspritzmaterial geschützt ist und der Tail nach dem Hinterspritzen problemlos von der Opferfolie wieder ablösbar ist. Dabei gibt es zwei Möglichkeiten: Zum Einen ist vorgesehen, dass die Opferfolie nach dem Hinterspritzen als Teil des Hinterspritzkörpers an diesem verbleibt. Zum Anderen ist es möglich, dass die Opferfolie nach erfolgtem Hinterspritzen auch vom Hinterspritzkörper wieder abgezogen wird. Die Opferfolie lässt sich auch als Abdeckfolie oder auch als Schutzfolie bezeichnen.

Entsprechend ist Gegenstand der Erfindung ein Verfahren zum Hinterspritzen einer Schichtelektrode zum Herstellen eines Berührungssensors, wobei die Schichtelektrode zumindest einen nicht zu hinterspritzenden Bereich aufweist, folgende Verfahrensschritte umfassend:
Abdecken des Bereichs der Schichtelektrode, der nicht zu hinterspritzen ist, mit einer Opferfolie,
Einbringen der Schichtelektrode und der Opferfolie in ein Hinterspritzwerkzeug, Hinterspritzen der Schichtelektrode und der Opferfolie
Bildung des Berührungssensors aus dem hergestellten Hinterspritzkörper.

Ebenso ist Gegenstand der vorliegenden Erfindung ein Folienkörper für eine Schichtelektrode eines Berührungssensors, einen frei zu bleibenden Bereich und eine Opferfolie umfassend, wobei die Opferfolie mit der Schichtelektrode einen Verbund bildet, in dem der frei zu bleibenden Bereich von der Opferfolie zwar vollständig bedeckt ist, sich aber leicht von dieser ablösen lässt. Schließlich ist Gegenstand der Erfindung ein Hinterspritzwerkzeug für das Hinterspritzen einer Schichtelektrode, erste Vakuumlinien für die Halterung der Schichtelektrode während des Hinterspritzen-Vorgangs und zweite Vakuumlinien für die Halterung einer Opferfolie während des Hinterspritz-Vorgangs aufweisend, wobei die ersten und zweiten Vakuumlinien, insbesondere unabhängig voneinander, ansteuerbar sind.

Nach einer bevorzugten Ausführungsform des Verfahrens erfolgt die Einspritzung so, dass möglichst wenig Hinterspritzmaterial zwischen einen frei zu bleibenden Bereich der Schichtelektrode, insbesondere den Tail und die Opferfolie gelangt.

Dazu wird eine Öffnung des Hinterspritzwerkzeugs zum Einspritzen des Hinterspritzmaterials ausgesucht, durch die aufgrund ihrer Abmessungen, ihrer Kontur und/oder v.a. dem Ort ihrer Anordnung das Hinterspritzmaterial auf den Folienkörper an einer Stelle trifft, an der keine Lücke zwischen der Opferfolie und der Schichtelektrode vorhanden ist und/oder die Opferfolie mit der Schichtelektrode abdichtend verbunden ist.

Nach einer bevorzugten Ausführungsform hat die Opferfolie zumindest die Ausmaße des frei zu bleibenden Bereichs, also beispielsweise des Tails.

Die Opferfolie hat zumindest die Ausmaße des Bereichs der Schichtelektrode, der frei bleiben soll, insbesondere beispielsweise des Tails, bevorzugt überragt sie diesen, damit eine nicht ganz passgenaue Platzierung nicht dazu führt, dass Teile des Bereichs doch hinterspritzt und damit verklebt werden.

Nach einer anderen bevorzugten Ausführungsform hat die Opferfolie einen rechteckigen, beispielsweise auch einen quadratischen Umriss.

Die Schichtelektrode umfasst bevorzugt eine transparente Kunststofffolie, insbesondere eine aus einem Polyolefin wie Polyethylenterephtalat (PET) oder Polycarbonat (PC) die mit leitfähigen, nicht transparenten, beispielsweise metallischen Leiterbahnen so bedruckt ist, dass Leitfähigkeit gewährleistet ist bei gleichzeitiger Transparenz der Folie für das menschliche Auge. Diese leitfähigen Folien sind beispielsweise aus der DE 10 2009 014 757.8 bekannt.

Nach einer Ausführungsform des Verfahrens wird die Opferfolie lose auf den Bereich der Schichtelektrode, der nicht hinterspritzt werden soll, gelegt, wobei am Hinterspritzwerkzeug Mittel, insbesondere Vakuumlinien vorgesehen sind, die zum einen die Schichtelektrode und zum anderen die Opferfolie in dem Hinterspritzwerkzeug fixieren.

Beispielsweise kann nach erfolgter Fixierung der Schichtelektrode durch erste Vakuumlinien die Opferfolie durch zweite Vakuumlinien fixiert werden.

Die beiden Vakuumlinien können beispielsweise unabhängig voneinander angesteuert werden und können bei gleichem oder verschiedenem Druck betrieben werden.

Nach einer weiteren Ausführungsform der Erfindung wird die Opferfolie vor Einbringung in das Hinterspritzwerkzeug auf den frei zu bleibenden Bereich der Schichtelektrode, beispielsweise den Tail, aufgebracht und mit diesem in dem Hinterspritzwerkzeug fixiert.

Dazu gibt es mehrere Techniken, die gemäß der Erfindung vorgeschlagen werden: Zum einen kann die Opferfolie ganzflächig durch eigene Adhäsionskraft oder durch eine adhäsive Zusatzschicht mit dem frei zu bleibenden Bereich der Schichtelektrode verklebt werden.

Dann ist es möglich, die Opferfolie über einen Falz mit dem frei zu bleibenden Bereich gemeinsam herzustellen und bei gewünschter Abdeckung die Opferfolie einfach umzuknicken bzw. wegzuknicken, so dass der darunter liegende Bereich der Schichtelektrode bedeckt und damit vor der Hinterspritzung geschützt ist.

Schließlich ist es möglich, die Opferfolie einfach über ein Klebeband auf der Schichtelektrode an der Stelle zu fixieren, wo sie abdecken soll.

Bei all diesen Methoden liegt beim Einbringen der Schichtelektrode in das Hinterspritzwerkzeug nur ein Folienkörper vor, der im Hinterspritzwerkzeug fixiert werden muss. Deshalb reichen nach diesen Ausführungsformen auch herkömmliche Hinterspritzwerkzeuge mit nur einer Reihe Vakuumlinien aus.

Egal wie die Opferfolie auf dem frei zu bleibenden Bereich der Schichtelektrode, insbesondere dem Tail, vor und während des Hinterspritzens gehalten wird, ist es wichtig, dass die Verbindung des frei zu bleibenden Bereichs zur Opferfolie leicht lösbar ist, also beispielsweise über Vakuumlinien, Releasekleber, Längsstreifenkleber und/oder Adhäsionskleber erfolgt. Nach dem Hinterspritzen wird die hinterspritzte Opferfolie von dem frei zu bleibenden Bereich, also beispielsweise dem Tail, ohne diesen zu beschädigen, beispielsweise auch durch Zerschneiden, wieder gelöst und/oder abgezogen.

Nach einer bevorzugten Ausführungsform der Erfindung verbleibt die Opferfolie als Teil des Hinterspritzkörpers auf diesem und wird beispielsweise auch ein Teil der Schichtelektrode im Berührungssensor nach der Bildung der Schichtelektrode aus dem hergestellten Hinterspritzkörper.

Die Opferfolie bedeckt vor dem Schließen des Hinterspritz-Werkzeugs den frei zu bleibenden Bereich der Schichtelektrode, also beispielsweise den Tail, ganzflächig und bevorzugt bündig abschließend. Wenn die Abdeckung des frei zu bleibenden Bereichs durch die Opferfolie nicht rundherum dicht ist, dann wird die Einspritzrichtung so angepasst, dass aller Wahrscheinlichkeit nach kein oder nur wenig Hinterspritzmaterial zwischen die Opferfolie und den frei zu bleibenden Bereich gelangt.

Das Hinterspritzwerkzeug wird geschlossen, und der Hinterspritz-Vorgang beginnt. Nach beendeter Hinterspritzung hat sich die Opferfolie mit dem Hinterspritzmaterial verbunden und der Tail liegt auf der Opferfolie und kann frei bewegt werden. Dabei ist es möglich, dass die Opferfolie Teil des Hinterspritzkörpers geworden ist oder sich auch von diesem abziehen lässt.

Die Schichtelektrode wird nach beendeter Hinterspritzung aus dem Hinterspritzkörper gebildet, insbesondere herausgeschnitten, beispielsweise mit Laserstrahl.

Die Opferfolie kann jede Art von Folie sein, die beispielsweise polymer aufgebaut ist und aus organischem Material besteht. Die Opferfolie soll nicht mit dem Material des Tails, vornehmlich Metall oder eine Metalllegierung, chemisch wechselwirken. Dies gilt auch für alle Arten von Zusätzen, sowohl auf dem Tail als auch auf der Opferfolie.

Nach einer vorteilhaften Ausführungsform ist die Opferfolie besonders dünn, beispielsweise liegt die Folienstärke im Bereich von 1 bis 250 µm insbesondere bevorzugt von 2 bis 100 µm und insbesondere bevorzugt von 5µm bis 75µm.

Ganz besonders bevorzugt haben die Opferfolie und die Trägerfolie der Schichtelektrode die gleiche Dicke. Hierdurch ergeben sich in vorteilhafter Weise gleichartige Vorzugscharakteristiken an beiden Folien während des Hinterspritzvorgangs. Dadurch kann beispielsweise die Wahl der Hinterspritz-Parameter erleichtert werden.

Als Trägerfolie der Schichtelektrode wird gemäß der DE 10 2012 112 445.0 hier die transparente Folie bezeichnet, auf der die leitfähigen Strukturen zur Bildung der leitfähigen Funktionsfolie aufgedruckt sind.

Nach einer weiteren Ausführungsform ist die Opferfolie transparent.

Das Material der Opferfolie hingegen ist beliebig, auch eine dünne Metallschicht und/oder eine dünne Glasschicht können hier als Opfer-Folie bezeichnet werden, weil diese Materialien sich in dünnster Form wie Folien verhalten. Insbesondere aber ist auch natürlich mit Opferfolie eine herkömmliche, in der Technologie genutzte Folienart, wie die üblichen Folienmaterialien, PET, PC, Polypropylen, Polyanilin und/oder Polyimid bezeichnet.

Nach einer besonders vorteilhaften Ausführungsform ist die Opferfolie kompatibel mit der Trägerfolie der Schichtelektrode, so dass nach dem Hinterspritzen die Opferfolie vom Hinterspritzmaterial gar nicht erst getrennt werden muss. Dies insbesondere deshalb, da die Opferfolie die Trägerfolie der Schichtelektrode lediglich an der Stelle, wo der Tail gebildet ist, verstärkt.

Im Folgenden wird die Erfindung anhand von Figuren, die beispielhafte Ausführungsformen des Folienkörpers und des Hinterspritz-Werkzeugs zeigen, näher erläutert.

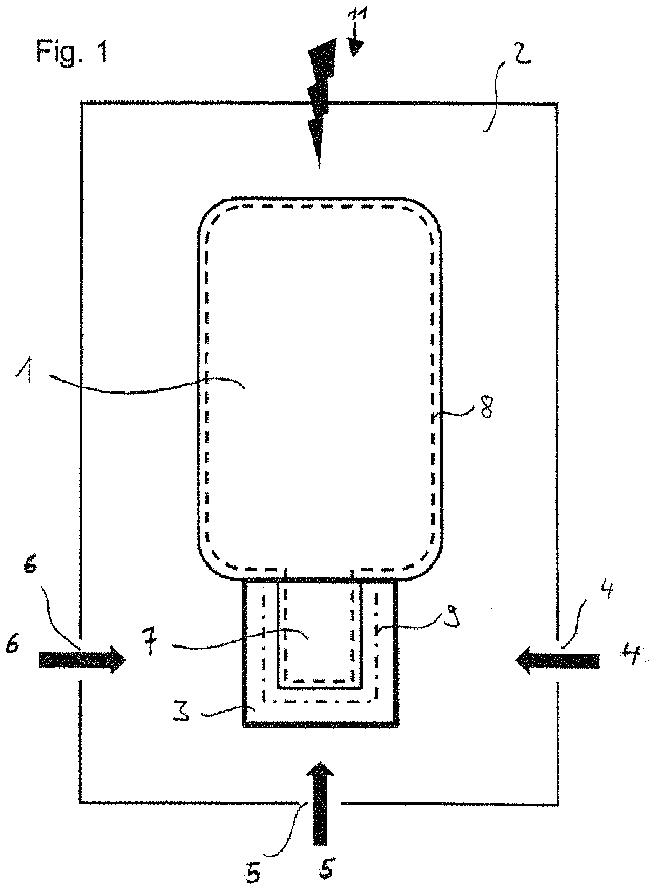

Figur 1 zeigt eine Schichtelektrode 1 und eine Opferfolie 3, die in ein Hinterspritzwerkzeug 2 eingelegt sind. Die Schichtelektrode 1 mit dem Tail 7 wird über die im Hinterspritzwerkzeug 2 ausgebildete Vakuumlinie 8 gehalten, während die Opferfolie 3 über die davon verschiedene zweite Vakuumlinie 9 gehalten wird. Dies ist erforderlich, da in diesem Ausführungsbeispiel kein zusammenhängender Folienkörper existiert, welcher sowohl die Schichtelektrode 1 als auch die Opferfolie 3 umfasst. Vielmehr liegen hier die Schichtelektrode 1 als erste Folie und die Opferschicht 3 als davon unabhängige, zweite Folie nur lose aufeinandergelegt, ohne Verbindung untereinander, vor.

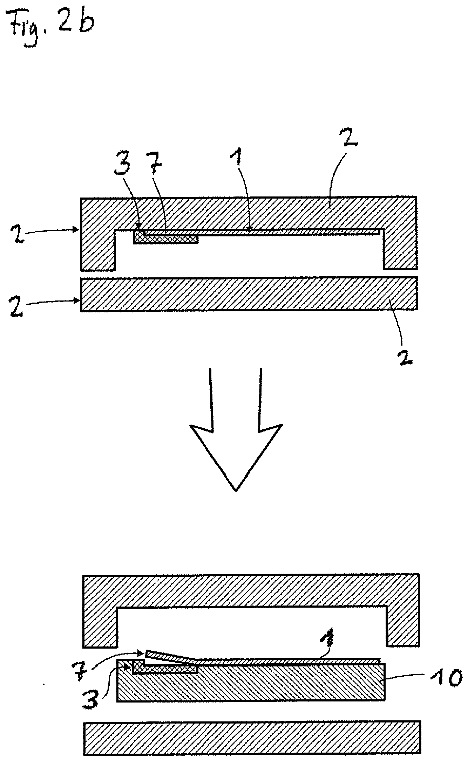

Das Einspritzen des Hinterspritzmaterials zur Ausbildung des Hinterspritzkörpers 10 (Figur 2b) erfolgt bei der in Figur 1 gezeigten Ausführungsform durch Öffnungen 4, 5 oder 6. Die Richtungen, aus denen das Hinterspritzmaterial (nicht gezeigt) in das Hinterspritzwerkzeug 2 gelangt, sind hier durch schwarze Pfeile gekennzeichnet. Von oben aus der Richtung 11 kommt ein versetzter Pfeil, welcher anzeigt, dass die Richtung 11 keine bevorzugte Richtung ist, aus der Hinterspritzmaterial in das Hinterspritzwerkzeug 2 aus Figur 1 eingeführt wird. Wenn nämlich das Hinterspritzmaterial aus der Richtung käme, dann könnte es sich bei der hier gezeigten Ausführungsform zwischen die Opferfolie 3 und die Schichtelektrode 1 oder den Tail 7 schieben und somit genau die Opferfolie vom Tail 7 abheben.

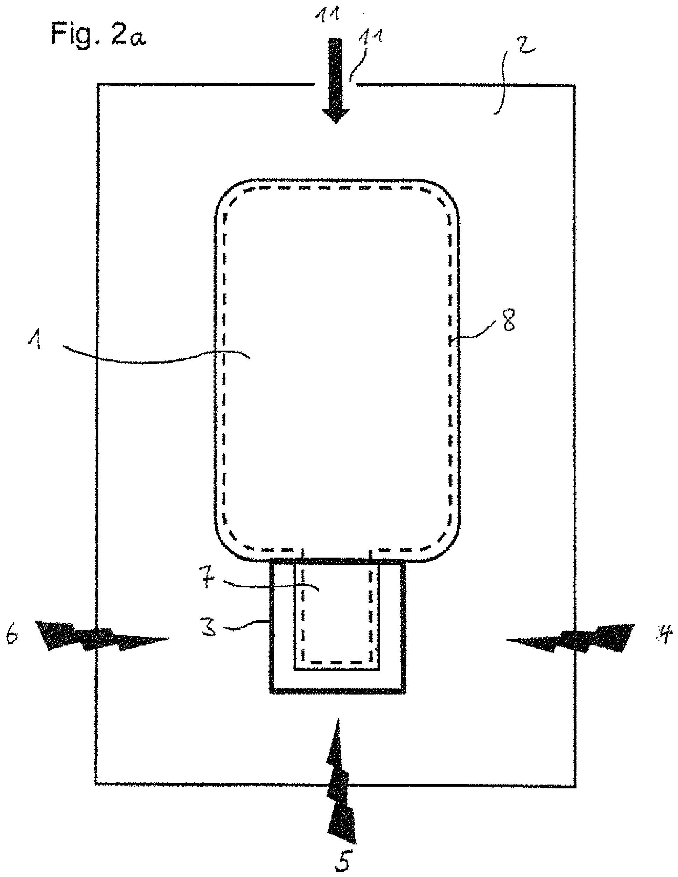

Im Ausführungsbeispiel der Figuren 2a und 2b liegt die Opferfolie 3 im Verbund mit der Schichtelektrode 1 vor. Figur 2a zeigt die Draufsicht auf den Folienkörper aus Schichtelektrode 1, Tail 7 und Opferfolie 3. Figur 2b zeigt dann im Querschnitt die Lage des Folienkörpers aus Figur 2a im Hinterspritzwerkzeug 2 vor dem Hinterspritzen (Figur 2b oben) und nach dem Hinterspritzen (Figur 2b unten).

Die Ausführungsform gemäß Figur 2a unterscheidet sich in der Ausführungsform von Figur 1 dadurch, dass hier die Opferfolie 3 mit der Schichtelektrode 1 verbunden ist. Deshalb entfällt hier die zweite Vakuumlinie 9 zur Fixierung der Opferfolie 3 im Hinterspritzwerkzeug 2. Die Opferfolie 3 wird an der Schichtelektrode 1 als Teil des Folienkörpers aus Schichtelektrode 1, Tail 7 und Opferfolie 3 gehalten und mit der Schichtelektrode 1 und dem Tail 7 über die Vakuumlinie 8 im Hinterspritzwerkzeug 2 fixiert. Beispielsweise ist die Opferfolie 3 über eine Zusatzschicht, wie eine Adhäsionsschicht (nicht gezeigt), an die Schichtelektrode 1 gebunden.

Nach einer Ausführungsform kann die Opferfolie 3 selbst als Adhäsionsschicht ausgebildet sein, so dass keine Zusatzschicht erforderlich ist. Dabei ist es insbesondere wichtig, dass der Folienkörper so verbunden ist, dass der Tail 7 nach dem Hinterspritzen (Figur 2b unten) von der Opferfolie 3 ablösbar ist. Für den Fall, dass die Opferfolie 3 als Adhäsionsschicht ausgebildet ist, ist diese stabil und unempfindlich gegenüber den beim Hinterspritzen auftretenden Bedingungen wie hohe Temperaturen etc.

Bei der in Figur 2a gezeigten Ausführungsform der Erfindung kommt das Hinterspritzmaterial bevorzugt durch die Öffnung 11 des Hinterspritzwerkzeugs 2, also von oben. Die beiden seitlichen Öffnungen 4 und 6 sowie die untere Öffnung 5 sind hingegen weniger bevorzugt, weil Hinterspritzmaterial unter die Opferfolie 3 kriechen könnte.

In Figur 2b ist schließlich gezeigt, wie das Hinterspritzen im Hinterspritzwerkzeug 2 abläuft.

Zunächst wird der Folienkörper aus Schichtelektrode 1, Tail 7 und Opferfolie 3 über Vakuumlinien 8 (im Querschnitt nicht gezeigt) im Hinterspritzwerkzeug 2 oben gehalten. Dann wird das Hinterspritzwerkzeug 2 geschlossen und das Hinterspritzmaterial eingespritzt (nicht gezeigt). Nach Beendigung des Hinterspritzens liegt ein Hinterspritzkörper 10 vor, auf dessen Oberseite die Schichtelektrode 1 liegt, deren Tail 7 nicht direkt hinterspritzt ist, sondern der auf der Opferfolie 3 liegt, die ihrerseits hinterspritzt ist. Die Materialien sind dabei so gewählt, dass der Tail 7 von der Opferfolie 3 leicht abgelöst werden kann. Dies kann auch bei Vorliegen einer Opferfolie 3, die eine Adhäsionsfolie ist, der Fall sein.

Beispielsweise kann für eine Ausführungsform der Erfindung gemäß der Figur 2 eine Opferfolie 3 aus einem Material wie
Polyethylen (PE) und/oder Polyvinylchlorid (PVC) sein, beide dadurch ausgezeichnet, dass sie sehr glatte Oberflächen haben und dann mit einem Hinterspritzmaterial wie Polymethylmethacrylat (PMMA), Polycarbonat (PC), Acrylnitril-Butadien-Styrol (ABS) hinterspritzt werden.

Die Anhaftung der Opferfolie 3 an die Schichtelektrode 1 kann insbesondere auch ohne Klebstoff allein mittels van-der-Waals Wechselwirkung erfolgen.

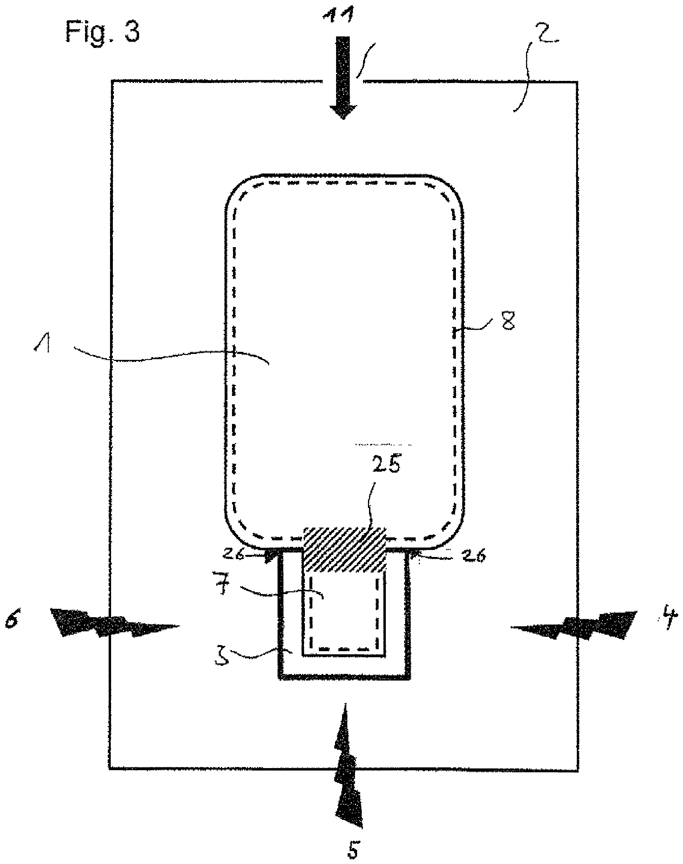

Figur 3 zeigt eine alternative Ausführungsform zum Folienkörper, die Schichtelektrode 1, den Tail 7 und die Opferfolie 3 umfassend, von Figur 2.

Zu erkennen sind in Figur 3 wieder die Schichtelektrode 1, die Vakuumlinie 8 des Hinterspritzwerkzeugs 2, der Tail 7, die ihn bedeckende Opferfolie 3 und die für die Hinterspritzung dieser Ausführungsform ungeeigneten Öffnungen 4, 5 und 6, sowie die geeignete Öffnung 11, aus der das Hinterspritzmaterial während der Hinterspritzung dieser Ausführungsform in geeigneter Weise kommt.

Die in Figur 3 gezeigte Ausführungsform der Erfindung unterscheidet sich von der in Figur 2a gezeigten dadurch, dass hier die Opferfolie 3 mit der Schichtelektrode 1 nicht durch eine Zusatzschicht oder durch eine adhesive Eigenschaft der Opferfolie 3 selbst, verbunden ist, sondern durch einen Klebestreifen 25, der nur im Verbindungsbereich von Schichtelektrode 1 mit Tail 7 die Opferfolie 3 mit der Schichtelektrode 1 verbindet.

Hier ist nur eine beispielhafte Länge des Klebestreifens 25 gezeigt, dieser kann sich auch weiter, bis hin über die ganze Länge der Verbindungslinie 26 von Schichtelektrode 1 mit der Opferfolie 3 erstrecken. Ebenso gut kann sich der Klebestreifen 25 auch nur abschnittsweise entlang der Verbindungslinie 26 befinden. Die Schichtabfolge des hier in Figur 3 gezeigten Folienkörpers entlang der Verbindungslinie 26 lässt sich demnach wie folgt beschreiben, zuunterst die Schichtelektrode 1 mit dem Tail 7, die im Hinterspritzwerkzeug 2 über die Vakuumlinien 8 gehalten werden. Darauf befindet sich lose aufeinandergelegt die Opferfolie 3, darüber dann der Klebestreifen 25, der die Opferfolie 3 mit der Schichtelektrode 1 verbindet.

Auch hier, wie bei dem Ausführungsbeispiel aus Figur 2 ist die Einspritzrichtung 11 gegenüber den Einspritzrichtungen 4, 5 und 6 bevorzugt, weil aus diesen Öffnungen eingespritztes Material unter die Opferfolie 3 kriechen könnte und dann doch der frei zu bleibenden Bereich, im gezeigten Beispiel der Tail 7, hinterspritzt werden würde.

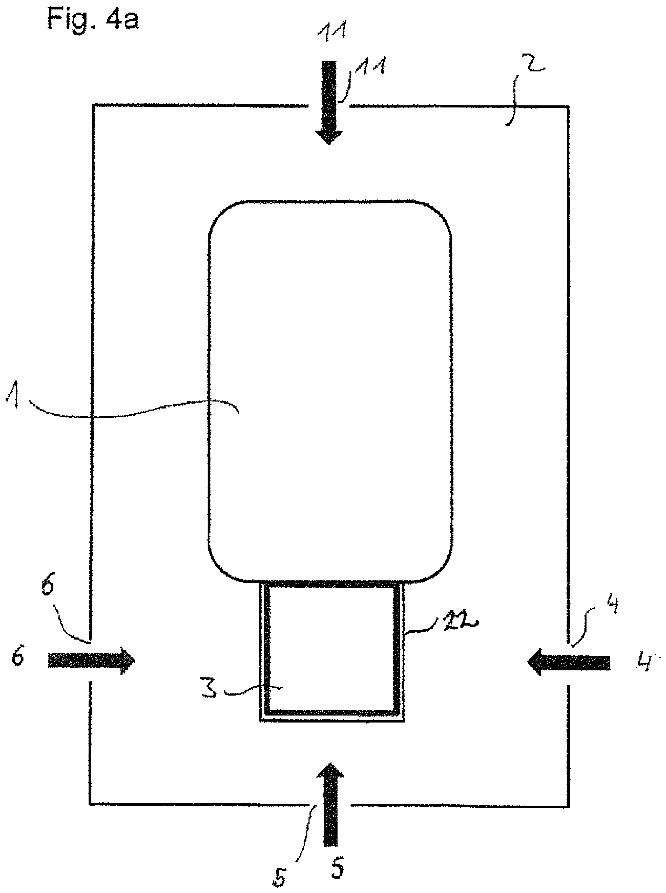

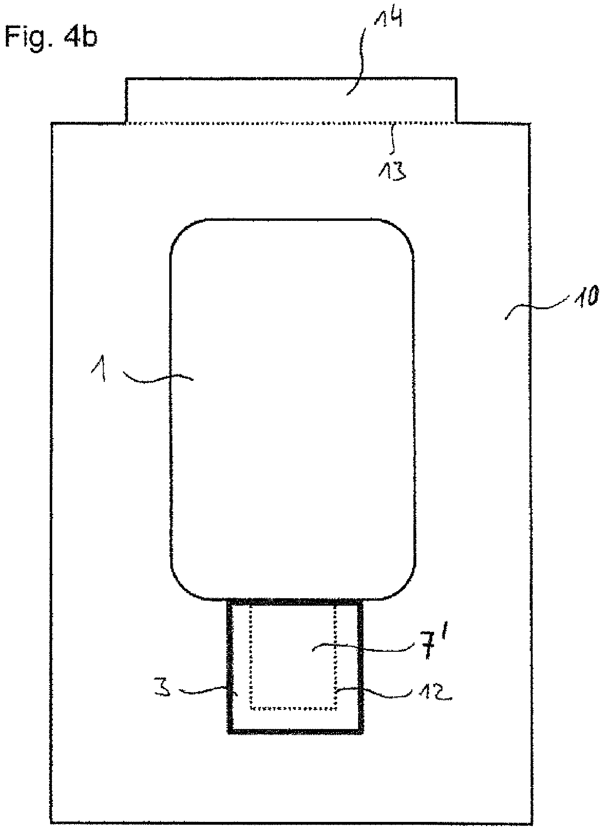

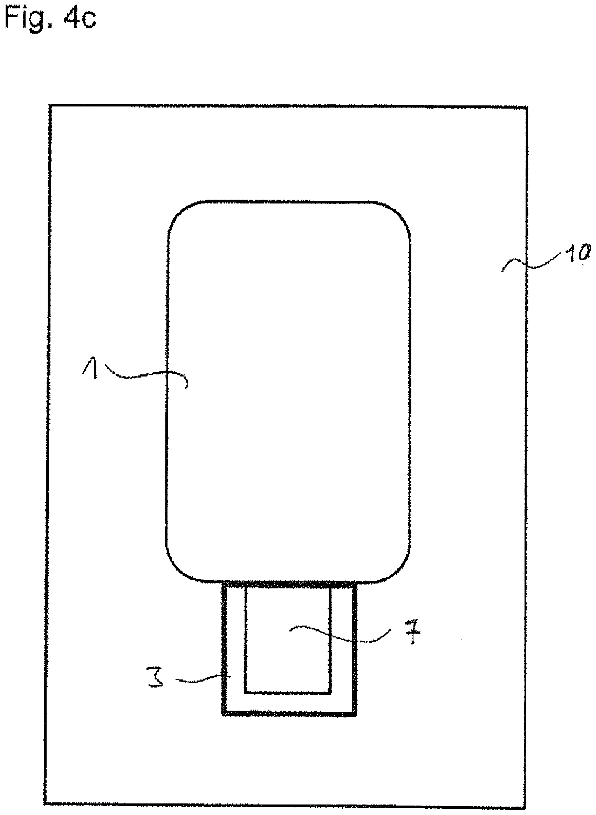

Figuren 4a, 4b und 4c zeigen den Ablauf einer Ausführungsform des erfindungsgemäßen Verfahrens. Wie in Figur 4a gezeigt, hat die Schichtelektrode 1 in der Umgebung des Tails 7 den Konturverlauf 22. Der Konturverlauf 22 stimmt mit jenem der Opferfolie 3 überein und ist in der Darstellung lediglich der Einfachheit halber versetzt gezeichnet. In der hier gezeigten Ausführungsform ist die Opferfolie 3 gemäß Figur 2 an den Tail 7 angeklebt, entweder durch eine Zusatzschicht die beide Folien miteinander verklebt und/oder dadurch, dass die Opferfolie 3 selbst adhäsive Eigenschaften aufweist.

Die Konturen 22 stimmen in der Ausführungsform in Wirklichkeit mit denen der Opferfolie 3 überein, so dass am Ende der Schichtelektrode 1, wo später der angelegte Tail 7 realisiert wird, ein Verbund aus dem angelegten Tail 7 der Schichtelektrode 1, der Opferfolie 3 und gegebenenfalls noch einer Zusatzschicht (nicht gezeigt) vorliegt. Der Umriss des Tails 7, wie er beispielsweise nach dem Hinterspritzen und Schneiden vorliegt, wird im hier gezeigten Ausführungsbeispiel erst nach der Hinterspritzung strukturiert.

Da der Konturverlauf 22 der Schichtelektrode 1 in der Umgebung des Tails 7 an drei Seiten bündig mit der Opferfolie 3 einen Verbund bildet, kann Hinterspritzmaterial nicht zwischen beide Folien kriechen und es gibt entsprechend hier keine Vorzugsrichtung und/oder Vorzugsöffnung, aus der die Einspritzung des Hinterspritzmaterials erfolgt.

In Figur 4b sieht man die Schichtelektrode 1 nach der Hinterspritzung. Es ist also ein Hinterspritzkörper 10 nach den Abmessungen des Hinterspritzwerkzeugs ausgebildet. Dieser weist eine Anspritzlasche 14 auf, die zeigt, dass die Einspritzung über die Öffnung 11 (Figur 4a) erfolgt ist. Ein Berührungssensor, die hinterspritzte Schichtelektrode 1 umfassend, wird nun aus dem Hinterspritzkörper 10 herausgeschnitten. Dazu wird beispielsweise ein Laserstrukturierungsprozess eingesetzt. Der Tail 7 ist noch nicht herausgeschnitten, sondern nur im Bereich 7' angelegt. Durch Schneiden, also beispielsweise Applizieren eines Laserstrahls entlang der Schnittlinie 12 wird der Tail 7 gebildet. Hierbei kann die Laserintensität beispielsweise so gewählt werden, dass der Laserstrahl zumindest die Schichtelektrode 1 von ca. 50µm Dicke so durchtrennt, dass die Konturen des Tails 7 entstehen. Alternativ dazu kann mit höherer Laserintensität beispielsweise auch die Opferfolie 3 strukturiert oder geschnitten werden. Alternativ oder ergänzend dazu kann mit einem entsprechend eingestellten Laserstrahl auch die Anspritzlasche 14 entlang der Schnittlinie 13 abgetrennt werden. Die Laserstrukturierung kann in einem Arbeitsgang erfolgen, wobei jeweils verschiedene Laserstrahlintensitäten für verschiedene Schnitte 12 oder 13 eingesetzt werden.

In Figur 4c ist das Ergebnis des Verfahrens gezeigt: Der mit der Opferfolie 3 hinterlegte Tail 7 ist ausgebildet, die Anspritzlasche 14 ist entfernt. Zu erkennen ist der Hinterspritzkörper 10, die Schichtelektrode 1 mit Tail 7 der mit einer Opferfolie 3 hinterlegt ist. Auf dem Hinterspritzkörper 10 liegt demnach im Bereich des Tail 7 zunächst die Opferfolie 3 und auf dieser der Tail 7, der von der Opferfolie 3 abgelöst werden kann oder nur lose auf dieser liegt.

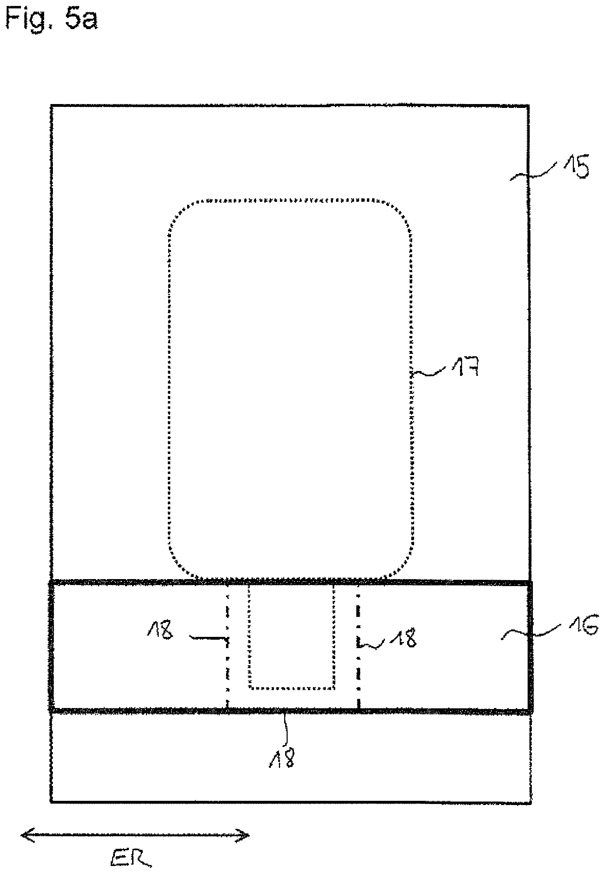

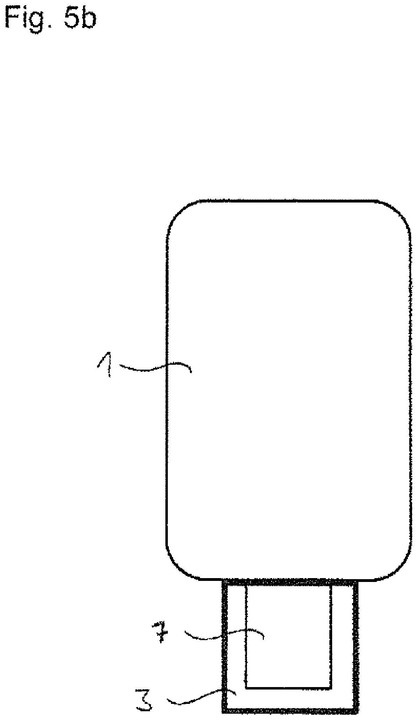

Die Figuren 5a und 5b zeigen beispielhaft ein Verfahren zur Herstellung des Folienkörpers beispielsweise gemäß Figur 2, bevor er hinterspritzt wird.

Figur 5a zeigt einen Ausschnitt aus einem Endlosband einer Folie 15, aus der eine erfindungsgemäße Schichtelektrode 1 bevorzugt gebildet ist. Diese Folien sind aus der DE 10 2009 014 575.8 bekannt und bevorzugt aus einem Polyolefin als transparentem Trägermaterial mit einem Muster aus leitfähigen Bahnen, wobei die Maße der Bahnen und das durch sie gebildete Muster so gewählt sind, dass die Folie zwar leitfähig ist, aber trotz der nicht transparenten leitfähigen Bahnen transparent für das menschliche Auge bleibt.

Auf diesem Endlosband aus Folie 15 ist ein dünneres Band 16 aufgebracht, aus dem die Opferfolien gebildet werden können. In Erstreckungsrichtung ER ist dieser Folienverbund aus Folie 15 und Band 16 beispielsweise kilometerlang und auf einer Rolle aufgewickelt. Vorteilhafterweise wird das Band im Rolle zu Rolle Verfahren strukturiert und verarbeitet. Beispielsweise wird entlang einer Schnittlinie 17 ein Laserstrahl mit einer ersten Intensität appliziert, um die Folie 15, beispielsweise mit einer Folienstärke im Bereich von 30µm bis 70 µm, zu durchtrennen. So können Schichtelektroden 1 mit Tails 7 aus dem Band herausgeschnitten werden. Bei dem darauffolgenden oder vorhergehenden Schnitt mit einem Laserstrahl geeigneter Intensität wird entlang der Schnittlinie 18 das Band mit dem Material für die Opferfolie 3, beispielsweise mit einer Folienstärke im Bereich von 50µm bis 100µm durchtrennt. Da im Bereich der Konturen für die Opferfolie 3 das Band 16 und das Band 15 durchtrennt werden müssen, ist hier ein entsprechend geeigneter Laserstrahl, der beide Folien schneiden kann, zu wählen.

Nach dem Verfahren kann ein Folienkörper, wie er in Figur 2a gezeigt ist, hergestellt werden. Dieser ist in Figur 5b nochmals dargestellt mit Schichtelektrode 1, Tail 7 und Opferfolie 3.

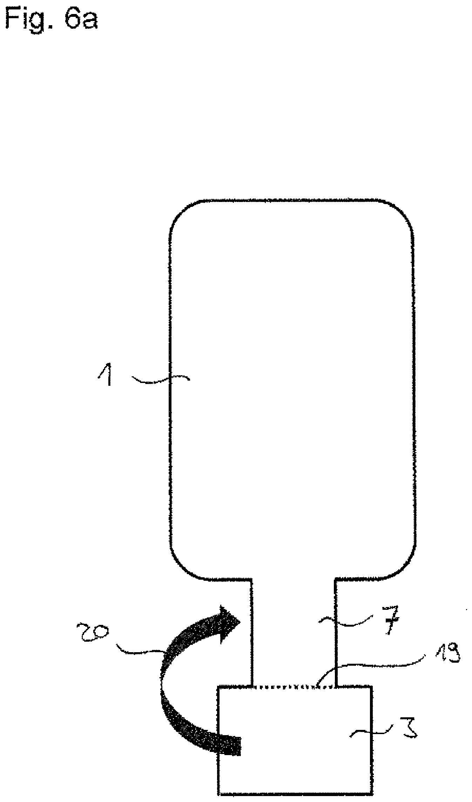

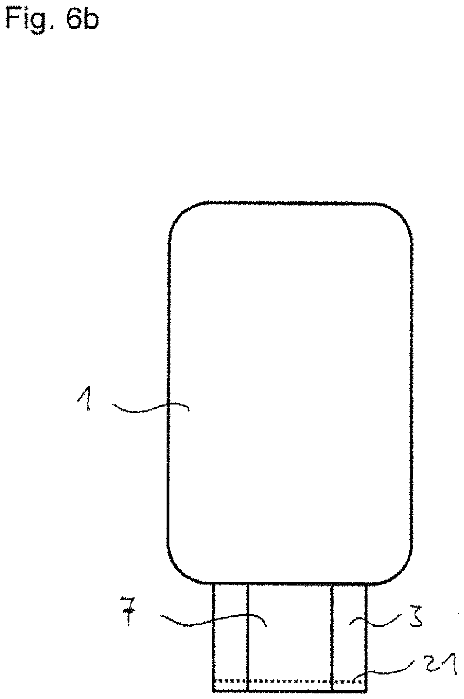

Alternativ kann der Folienkörper auch aus einem Band hergestellt werden, wie in Figur 6 gezeigt. Hier wird aus einer Lage eine Folie, die Schichtelektrode 1, Tail 7 und Opferfolie 3 umfasst, herausgeschnitten. Diese Folie weist eine Sollknickstelle 19 auf, entlang der die Folie so umgeknickt wird, dass die Opferfolie 3, die zunächst an den Tail 7 angrenzte, auf oder unter diesem liegt. Dazu wird die Folie entlang der Linie 19 und in Richtung 20 geknickt. Nach erfolgter Hinterspritzung wird der Knickstreifen 21 abgeschnitten, beispielsweise mittels Laserschneiden, wodurch der Tail 7 problemlos von der Opferfolie 3 abgelöst wird. In dem gezeigten Hinterspritzwerkzeug 2 wird diese Ausführungsform dann bevorzugt aus der Einspritzrichtung 5 hinterspritzt, da dann die entstehende Anspritzlasche (nicht gezeigt) mit der Knickkante 21 gemeinsam abgetrennt werden kann.

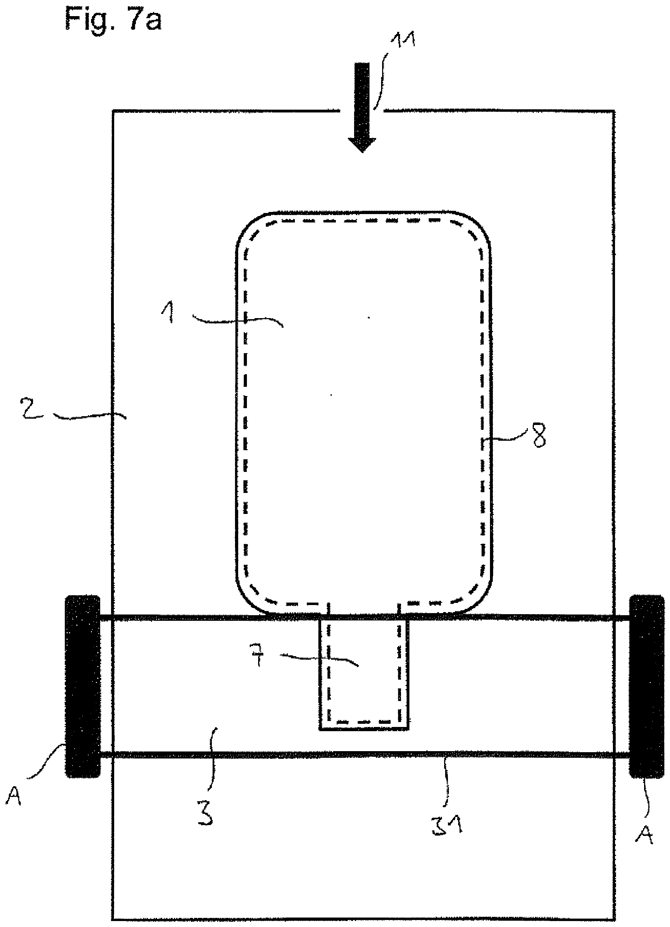

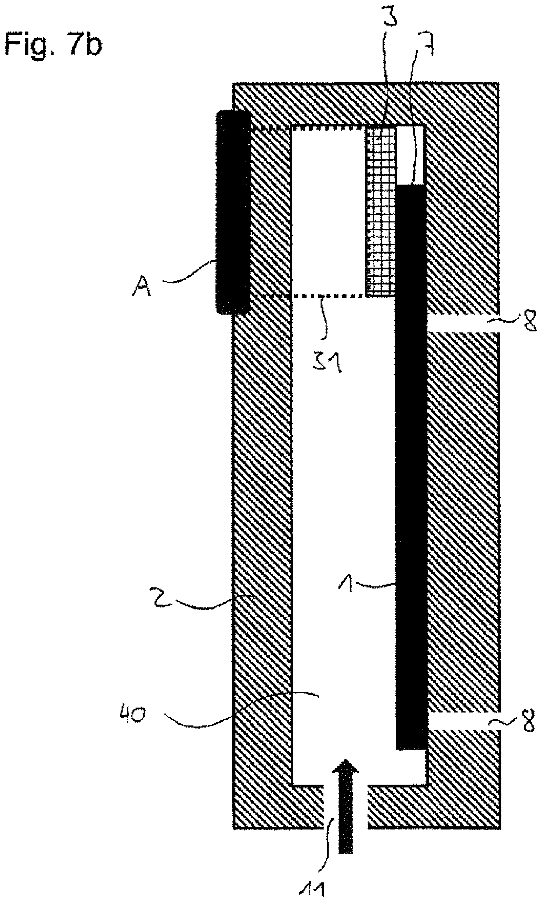

Figuren 7a und 7b zeigen ein Hinterspritzwerkzeug 2 mit einer Bandfixierung A, an welcher ein Schutzband 31 befestigt ist, welches die Funktion der Opferfolie 3 übernimmt. Wie man aus Figur 7b erkennt, ist bei geschlossenem Hinterspritzwerkzeug 2 das Schutzband 31 so angeordnet, dass es zwar weiterhin an der Bandfixierung A befestigt ist, jedoch so durchgewölbt ist, dass es sich an der Stelle des Tails 7 als Opferfolie 3 auf diesen anlegt. Beim Hinterspritzen wird zwar das Schutzband 31 mit hinterspritzt, kann jedoch anschließend nach oben aus seiner Position herausgeschoben werden, und damit einen Hinterspritzkörper 10 freilegen, der eine hinterspritzte Schichtelektrode 2 und einen freiliegenden Tail 7 umfasst. Mit 40 ist der Hohlraum im Hinterspritzwerkzeug 2 bezeichnet, in dem sich der Hinterspritzkörper 10 ausbildet.

Das Schutzband 31 wird nach erfolgter Hinterspritzung aus dem Hinterspritzwerkzeug 2 herausgeschoben und steht nach einer bevorzugten Ausführungsform für einen weiteren Hinterspritzvorgang zur Verfügung.

Dazu ist das Schutzband 31 vorteilhafterweise zumindest einseitig mit einer Antihaftbeschichtung ausgestattet. Beispielsweise hat das Schutzband 31 die Antihaftbeschichtung auf der dem Hinterspritzmaterial zugewandten Seite, so dass das Hinterspritzmaterial nicht auf dem Schutzband 31 anhaftet und das Herausziehen problemlos erfolgen kann.

Nach mehreren Hinterspritzvorgängen kann die Antihaftbeschichtung aufgebraucht/abgenutzt sein. Es kann deshalb vorgesehen sein, dass das Schutzband 31 als Endlosrolle an den Bandfixierungen A aufwickelbar angeordnet ist. Jeweils nach ein paar Hinterspritzvorgängen kann das Schutzband 31 weitergespult werden und es steht frisches Folienmaterial als Schutzband 31 zur Verfügung.

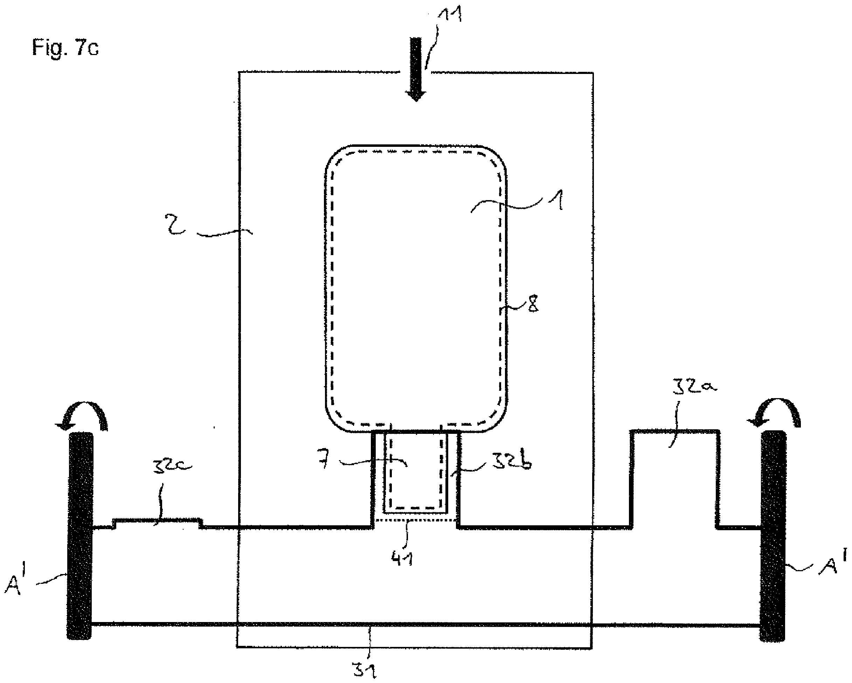

Figur 7c zeigt eine Variation dieser Ausführungsform des Verfahrens mit dem Schutzband 31: Am Schutzband 31 sind Laschen 32 a bis 32 c ausgebildet, die als Opferfolien 3 dienen. Beim Einbringen des Folienkörpers aus Schichtelektrode 1 mit Tail 7 in das Hinterspritzwerkzeug 2 kommt genau eine dieser Laschen 32a bis 32c des Schutzbandes 31 auf dem Tail 7 zu liegen. Nach dem Hinterspritzvorgang wird die Lasche 32b entlang der Konturlinie 41 abgetrennt. Die Abtrennung erfolgt beispielsweise durch Laserschneiden, kann aber auch durch Brechen einer Sollbruchstelle entlang der Konturlinie 41, die beispielsweise durch eine dort vorgesehene Perforation gebildet ist, ausgeführt werden. Das Brechen einer solchen Sollbruchstelle entlang der Konturlinie 41 kann beispielsweise einfach durch Weiterspulen des Schutzbandes 31 verursacht werden.

In Figur 7c ist diese Ausführungsform dadurch verbildlicht, dass vor dem Einbringen in das Hinterspritzwerkzeug 2 das Schutzband 31 von rechts kommend über eine Lasche 32a verfügt, die eine Sollbruchstelle (nicht gezeigt) hat. Das Schutzband wird zum Hinterspritzen nach links gespult, so dass die Lasche 32b dann zusammen mit dem Folienkörper aus Schichtelektrode 1 und Tail 7 hinterspritzt wird, wobei sie als Lasche 32 b den Tail 7 abdeckt. Nach dem Hinterspritzen wird das Schutzband 31 über die Endlosrollen A' zur Bandfixierung weiter nach links gespult, wobei die Sollbruchstelle entlang der Konturlinie 41 bricht und dadurch auf der anderen Seite des Hinterspritzwerkzeugs 2 das Schutzband 31 nur noch eine Anschlussstelle 32c zeigt. Der Hauptteil, als Lasche 32 b bezeichnet, verbleibt hier nach dem Hinterspritzen als Opferfolie 3 auf dem Hinterspritzkörper 10. Für den darauffolgenden Hinterspritzvorgang steht durch Weiterspulen mittels der Endlosrollen A' eine neue Lasche 32a des Schutzbandes 31 bereit.

### Bezugszeichenliste Nr 149

- 1: Schichtelektrode
- 2: Hinterspritzwerkzeug
- 3: Opferfolie
- 4: Öffnung rechts zum Einlass des Hinterspritzmaterials
- 5: Öffnung unten zum Einlass des Hinterspritzmaterials
- 6: Öffnung links zum Einlass des Hinterspritzmaterials
- 7: Tail
- 8: Vakuumlinie Schichtelektrode
- 9: Vakuumlinie Opferfolie
- 10: Hinterspritzkörper
- 11: Öffnung oben zum Einlass des Hinterspritzmaterials
- 12: Schnittlinie am Tail 7
- 13: Schnittlinie an der Anspritzlasche 14
- 14: Anspritzlasche
- 15: Leitfähige Folie
- 16: Opferfolienband
- 17: Schnittlinie für Schichtelektrode 1 und Tail 7
- 18: Schnittlinie für Opferfolie
- 19: Sollknicklinie für Faltung
- 20: Faltrichtung
- 21: Knickstreifen
- 22: Konturverlauf

- 25: Klebestreifen
- 26: Verbindungslinie zwischen Opferfolie 3 und Schichtelektrode 1
- 31: Schutzband
- 32: Lasche am Schutzband
- 40: Hohlraum
- 41: Konturlinie an der Lasche 32 des Schutzbandes 31
- A: Bandfixierung
- A': Endlosrolle zur Bandfixierung

## Patentansprüche

1. *Verfahren zum Hinterspritzen einer Schichtelektrode (1) zum Herstellen eines Berührungssensors, wobei die Schichtelektrode (1) zumindest einen nicht zu hinterspritzenden Bereich (7) aufweist, folgende Verfahrensschritte umfassend:*
- *Abdecken des Bereichs (7) der Schichtelektrode (1), der nicht zu hinterspritzen ist, mit einer Opferfolie (3, 31, 32)*
- *Einbringen der Schichtelektrode (1) und der Opferfolie (3, 31, 32) in ein Hinterspritzwerkzeug (2)*
- *Hinterspritzen der Schichtelektrode (1) und der Opferfolie (3, 31, 32)*
- *Bildung des Berührungssensors aus dem hergestellten Hinterspritzkörper (10).*

2. *Verfahren nach Anspruch 1, wobei die Bildung des Berührungssensors aus dem hergestellten Hinterspritzkörper (10) durch ein Herausschneiden, insbesondere über Laserstrukturierung, erfolgt.*

3. *Verfahren nach einem der vorstehenden Ansprüche 1 oder 2, wobei die Opferfolie in Form eines Schutzbandes (31, 32) vorliegt.*

4. *Verfahren nach einem der vorstehenden Ansprüche, wobei das Abdecken des Bereichs (7) der Schichtelektrode (1), der nicht hinterspritzt wird, durch Knicken der Opferfolie (3, 31, 32) entlang eines Knickstreifens (21) erfolgt.*

5. *Verfahren nach einem der vorstehenden Ansprüche, wobei das Abdecken des Bereichs (7) der Schichtelektrode (1), der nicht hinterspritzt werden soll, durch Fixierung der Opferfolie (3, 31, 32) erfolgt.*

6. *Verfahren nach einem der vorstehenden Ansprüche, wobei in einem ersten Verfahrensschritt die Schichtelektrode (1) durch eine oder mehrere erste Vakuumlinien (8) im Hinterspritzwerkzeug (2) fixiert wird und in einem darauffolgenden Verfahrensschritt die Opferfolie (3, 31, 32) im Hinterspritzwerkzeug (2) fixiert wird.*

7. *Verfahren nach einem der vorstehenden Ansprüche, wobei die Opferfolie (3, 31, 32) von dem nicht zu hinterspritzenden Bereich (7) der Schichtelektrode (1) nach dem Hinterspritzen durch Ablösen, Abziehen, Zersetzung, Verdampfung und*/*oder Trocknung entfernt wird.*

## Claims

1. Method for back injection moulding a layered electrode (1) for the production of a contact sensor, wherein the layered electrode (1) has at least one region (7) that is not to be back injection moulded, said method comprising the following steps:
- covering the region (7) of the layered electrode (1) that is not to be back injection moulded with a sacrificial film (3, 31, 32),
- introducing the layered electrode (1) and the sacrificial film (3, 31, 32) into a back injection moulding tool (2),
- back injection moulding the layered electrode (1) and the sacrificial film (3, 31, 32),
- forming the contact sensor from the produced back injection moulded body (10).

2. Method according to claim 1, wherein the formation of the contact sensor from the produced back injection moulded body (10) takes place by way of excision, in particular by laser structuring.

3. Method according to one of the preceding claims 1 or 2, wherein the sacrificial film is present in the form of a protective strip (31, 32).

4. Method according to one of the preceding claims, wherein the covering of the region (7) of the layered electrode (1) that is not back injection moulded takes place by buckling the sacrificial film (3, 31, 32) along a buckling strip (21).

5. Method according to one of the preceding claims, wherein the covering of the region (7) of the layered electrode (1) that is not to be back injection moulded takes place by fixing the sacrificial film (3, 31, 32).

6. Method according to one of the preceding claims, wherein, in a first method step, the layered electrode (1) is fixed by one or more first vacuum lines (8) in the back injection moulding tool (2) and, in a subsequent method step, the sacrificial film (3, 31, 32) is fixed in the back injection moulding tool (2).

7. Method according to one of the preceding claims, wherein the sacrificial film (3, 31, 32) is removed from the region (7) of the layered electrode (1) that is not to be back injection moulded by detaching, pulling off, disintegrating, vaporisation and/or drying after the back injection moulding.

## Revendications

1. Procédé servant à l'injection par l'arrière d'une électrode à couche (1) servant à fabriquer un capteur tactile, dans lequel l'électrode à couche (1) présente au moins une zone (7) qui ne doit pas être injectée par l'arrière, comprenant des étapes de procédé qui suivent consistant à :
- recouvrir la zone (7) de l'électrode à couche (1), qui ne doit pas être injectée par l'arrière, d'une feuille sacrificielle (3, 31, 32),
- introduire l'électrode à couche (1) et la feuille sacrificielle (3, 31, 32) dans un outil d'injection par l'arrière (2),
- injecter par l'arrière l'électrode à couche (1) et la feuille sacrificielle (3, 31, 32),
- former le capteur tactile à partir du corps injecté par l'arrière (10) fabriqué.

2. Procédé selon la revendication 1, dans lequel la formation du capteur tactile a lieu à partir du corps injecté par l'arrière (10) fabriqué par un retrait par découpage, en particulier par une structuration au laser.

3. Procédé selon l'une quelconque des revendications 1 ou 2, dans lequel la feuille sacrificielle est présente sous la forme d'une bande de protection (31, 32).

4. Procédé selon l'une quelconque des revendications précédentes, dans lequel le recouvrement de la zone (7) de l'électrode à couche (1), qui n'est pas injectée par l'arrière, a lieu par le pliage de la feuille sacrificielle (3, 31, 32) le long d'un ruban de pliage (21).

5. Procédé selon l'une quelconque des revendications précédentes, dans lequel le recouvrement de la zone (7) de l'électrode à couche (1), qui ne doit pas être injectée par l'arrière, a lieu par la fixation de la feuille sacrificielle (3, 31, 32).

6. Procédé selon l'une quelconque des revendications précédentes, dans lequel lors d'une première étape de procédé, l'électrode à couche (1) est fixée par une ou par plusieurs premières lignes de vide (8) dans l'outil d'injection par l'arrière (2) et lors d'une étape de procédé qui suit, la feuille sacrificielle (3, 31, 32) est fixée dans l'outil d'injection par l'arrière (2).

7. Procédé selon l'une quelconque des revendications précédentes, dans lequel la feuille sacrificielle (3, 31, 32) est retirée de la zone (7), qui ne doit pas être injectée par l'arrière, de l'électrode à couche (1) après l'injection par l'arrière par décollement, arrachage, désintégration, évaporation et/ou séchage.
